# EUROPEAN PATENT SPECIFICATION

(11) **EP 0 533 201 B1**
(45) Date of publication and mention of the grant of the patent: **14.02.1996**
(21) Application number: 92116031.3
(22) Date of filing: 18.09.1992
(51) Int. Cl.: C23C 16/44, B01J 3/02, B01F 3/02

(54) **Liquid vaporization valve**
Flüssigkeitsverdampfungsventil
Vanne de vaporisation d'un liquide

(30) Priority: 18.09.1991 JP 238158/91
(43) Date of publication of application: 24.03.1993
(73) Proprietor: APPLIED MATERIALS JAPAN, INC., Shinjuku-ku, Tokyo (JP)
(72) Inventor: Nishizato, Hiroshi, 14-3, Shinizumi, Narita-shi, Chiba (jp); Iizuka, Hiroshi, 14-3 Shinizumi, Narita-shi, Chiba (jp); Suzuki, Hiromi, 14-3 Shinizumi, Narita-shi, Chiba (jp)
(74) Representative: DIEHL GLAESER HILTL & PARTNER

(56) References cited:
- EP-A- 0 435 088
- WO-A-91/19017
- FR-A- 2 019 215

## Description

This invention relates to an improved vaporization valve for a liquid vaporizer-feeder.

Recently, tetraethoxysilane Si(OC₂H₅)₄ in the following referred to as TEOS is coming to be seriously considered as a layer-to-layer insulating film material for semiconductor wafers. One of the reasons for this choice is its superior step coverage because the rate determination is by surface reaction. This is to be contrasted to the SiH₄ deposition mechanism in conventional reduced-pressure chemical vapor deposition (CVD). Another reason is that SiH₄ is extremely reactive, and there is a relatively high probability of an explosion. By contrast, TEOS is safer and easier to store. Moreover, its cost, as a source material, is expected to become lower in the future.

Examples of CVD using TEOS include the reduced-pressure CVD, the normal-pressure CVD and the plasma CVD. If a reaction chamber is used at a normal pressure as in the case of a normal-pressure CVD method, a pressure gradient should be generated inside the pipes because the source liquid would otherwise not flow through the pipes. In the case of the reduced-pressure or plasma CVD method, the source liquid naturally flows into the reaction chamber because the reaction chamber is in a reduced-pressure condition.

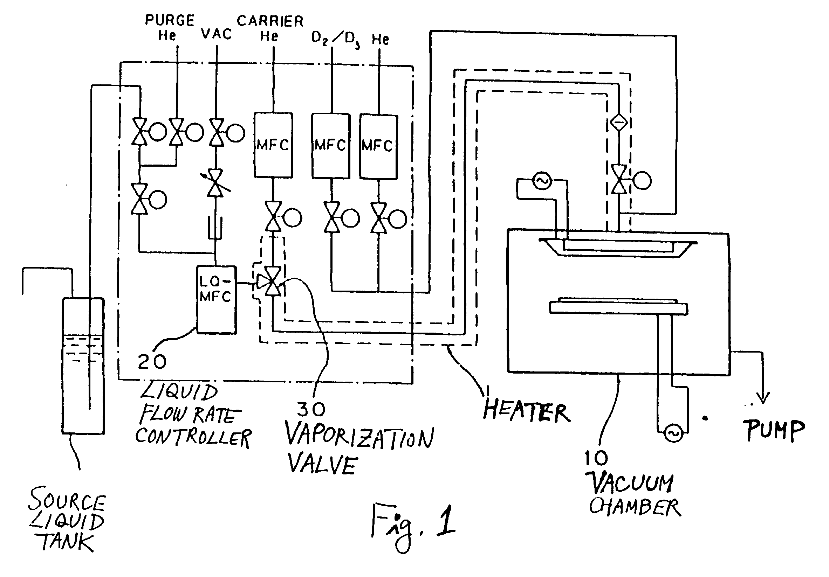

Fig. 1 is a schematic system diagram of a vaporizer-feeder for supplying a mixed gas into a reaction chamber. A semiconductor wafer is placed on a susceptor inside a vacuum chamber 10 serving as a reaction chamber. TEOS is passed through a liquid mass flow controller 20, vaporized in a liquid vaporization valve 30, mixed with a carrier gas, and sent into the vacuum chamber 10 with oxygen mixed together on the way. A high-frequency voltage is applied to an electrode inside the vacuum chamber 10 to generate a plasma and to thereby form a SiO₂ film on the semiconductor wafer. In Fig. 1, MFC indicates mass flow control means.

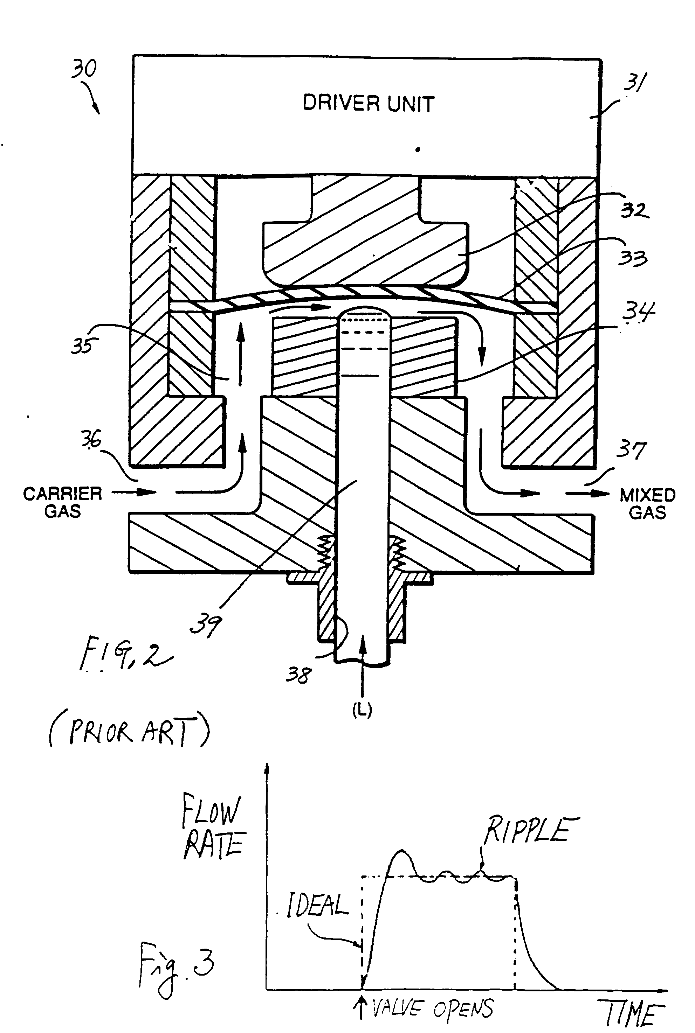

Examples of liquid feeder-vaporizer for vaporizing a liquid source and mixing it with a high-temperature carrier gas to transport it into a reaction area such as a vacuum chamber of Fig. 1 have been disclosed in Japanese Patent Applications 1-322266 and 3-36707. Fig. 2 is a sectional view of the three-way valve 30 disclosed in Japanese Patent Application 1-322266 for liquid vaporization, having an indented section with an open top. A driver unit 31 is disposed at the top so as to close this indented section from above. Use may be made, for example, of an air valve for accurately controlling the driver unit 31. The driver unit 31 has a plunger 32 protruding downward from the center of its lower surface. The plunger 32 can be raised and lowered by the operation of the driver unit 31. A flexible diaphragm 33 is at the center of the indented section, and its peripheries are air-tightly affixed to the inner walls of the indented section. A passageway 38 for the source liquid is connected to a liquid mass flow control device LQ-MFC (as shown at 20 in Fig. 1) and passes vertically through the center of the base member of the three-way valve 30. A valve seat 34 is attached to the top of the base and surrounds the source liquid supply passageway 38. The plunger 32 is aligned with the upper opening of the supply passageway 38 so as to be able to open or close this opening through the diaphragm 33. A control chamber 35 is formed below the diaphragm 33 and around the valve seat 34. Generally L-shaped gas inlet 36 and output 37 are provided on mutually opposite sides of the source liquid supply passageway 38, both leading to the control chamber 35. The gas inlet 36 is connected to high-pressure containers (not shown) for carrier and reaction gases through an isothermally heated pipe system. The gas outlet 37 is connected to the reaction chamber 10 through another isothermally heated piping system.

Next, the operation of the three-way valve 30 described above will be explained. As a source liquid 39 is supplied into the preliminarily heated supply passageway 38 and reaches the upper end of the valve seat 34, it comes into contact with the carrier gas and vaporizes to form a source gas. Since the source gas is carried away by the catrier gas as soon as it is thus generated, its pressure drops immediately and, in order to make up for this pressure drop, the incoming source liquid is quickly vaporized. By this sequence of events, the source liquid continues to be vaporized and carried away, forming a mixed gas to be introduced into the reaction chamber steadily at a constant rate. In other words, a desired gas mixture can be obtained by such a three-way valve by appropriately controlling the liquid mass flow controller 20.

When use is made of such a three-way valve for liquid vaporization, however, the liquid will boil when the plunger is raised to put the valve in the ON-condition because of the sudden drop in pressure along the liquid supply passageway between the three-way valve and the liquid mass flow controller. This will cause a mixture of vapor and liquid to occupy the supply passageway, and if more liquid is supplied through the passageway in such a condition, the incoming liquid will also start to boil. Thus, the flow rate of the source liquid delivered from the three-way valve to the reaction chamber will fluctuate, depending on the mixing ratio between the liquid and the vapor, showing a ripple as illustrated in Fig, 3 although it should change ideally as shown by the dotted line therein.

It is therefore an object of the present invention to provide an improved liquid vaporization valve capable of controlling the boiling of the liquid such that the liquid can be vaporized stably and hence a source gas can be obtained and delivered into a reaction chamber at a dependably steady rate.

This object is solved by the liquid vaporization valve of independent claim 1. Further advantageous features, aspects and details of the invention are evident from the dependent claims, the description and the drawings.

The invention provides a liquid vaporization valve capable of accurately controlling the supply of a liquid source, such as tetraethoxysilane Si(OC₂H₅)₄ (TEOS) for forming a thin film, into an apparatus for manufacturing semiconductor devices.

An improved liquid vaporization valve embodying the present invention, by which the above and other objects can be accomplished, may be characterized as being like the three-way valve described above except there is an elongated member with a tapered upper end inserted into the supply passageway for the source liquid such that the gap between its outer surface and the inner wall of the supply passageway is large enough to allow the source liquid to pass through but narrow enough to control its flow rate. According to another embodiment of the invention, the inserted member is not tapered, but the inner wall of the supply passageway for the source liquid is tapered. Within a three-way valve thus structured, a gap is formed between the inner wall of the liquid supply passageway and the external peripheral surface of the inserted member, and such a gap, when appropriately adjusted according to the rate of flow, serves to stabilize the boundary surface between the gas and liquid phases, thereby stabilizing the rate of vaporization.

The accompanying drawings, which are incorporated in and form a part of this specification, illustrate an embodiment of the invention and, together with the description, serve to explain the principles of the invention. In the drawings:
Fig. 1 is a schematic system diagram of a vaporizer-feeder for supplying a mixed gas into a reaction chamber;
Fig. 2 is a sectional view of a prior art three-way valve for vaporizing a source liquid and mixing it with a carrier gas;
Fig. 3 is a graph showing the ripple in the flow rate when the valve of Fig.2 is opened, as well as the change in the flow rate in an ideal situation;
Fig. 4 is a sectional view of a three-way liquid vaporization valve embodying the present invention; and
Figs. 5 and 6 are sectional views of portions of other three-way liquid vaporization valves embodying the present invention.

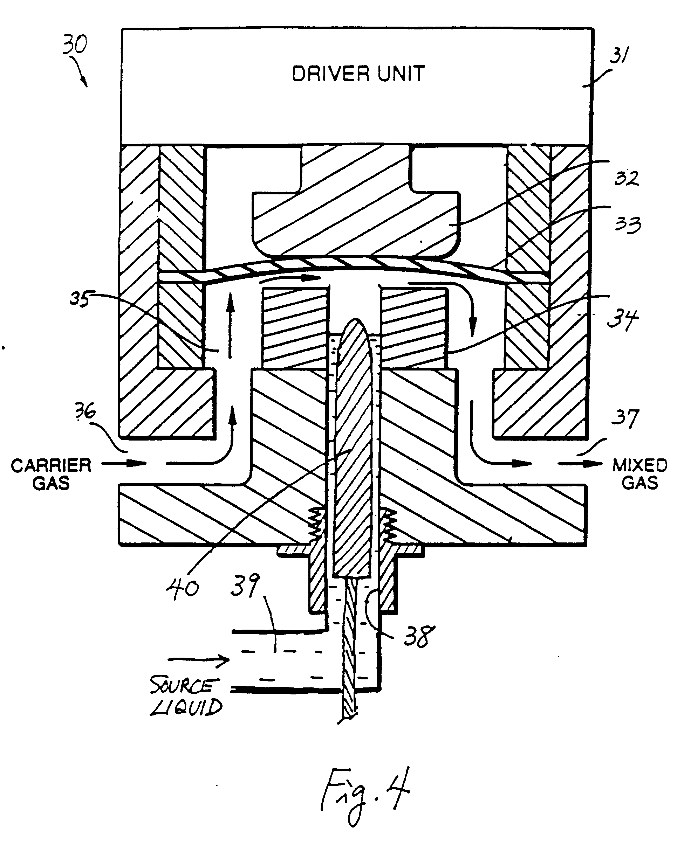

Fig. 4 shows a three-way liquid vaporization valve embodying the present invention, many components of which are substantially identical or at least structurally similar to those described above with reference to Fig. 2, and hence are indicated by same numerals and will not be explained again.

The valve shown at 30 in Fig. 4 is distinguishable from the prior art valve of Fig. 2 wherein an elongated member 40 is inserted into the passageway 38 for the source liquid. According to the embodiment of the invention illustrated in Fig. 4, the elongated member 40 extends in the direction of the passageway 38 and tapered towards the plunger 32. The gap created between the outer peripheral surface of this member 40 and the tubular inner wall of the passageway 38 is large enough to allow the source liquid 39 to pass therethrough, and a dead space of a controllable volume is left inside the passageway 38 above the member 40.

In using the valve 30 thus structured, the elongated member 40 is adjusted such that the boundary surface between the gas and liquid phases will be at an appropriate position with respect to the member 40. If the plunger 32 is thereafter raised to put the valve 20 in the ON-condition, the source liquid is vaporized smoothly by the carrier gas, and the vaporized source gas is mixed with the carrier gas at the top opening in the valve seat 34. The mixed gas then passes through the gas outlet 37 to be introduced into the reaction chamber 10.

The abrupt initial rise of the flow rate (or the so-called overshooting phenomenon) as the valve is put in the ON-condition, which causes ripples as shown in Fig. 3, can thus be eliminated by appropriately controlling the volume of the aforementioned dead space formed between the inserted member 40 and the diaphragm 33. Various shapes for the member 40 are acceptable, but those with a rounded end are preferred over those with a sharper end because the overall length of the passageway 38 can be reduced. The position of the member 40 is preferably such that the distance between its top end and the diaphragm 33 will be small when the valve is in the OFF-condition, reducing the aforementioned volume of the space. The reason for this choice is that the source liquid, which accumulates while the valve is off, is prevented from being supplied at an excessive rate, thereby eliminating the occurrence of the aforementioned overshooting phenomenon. Vaporization of the source liquid itself can also be controlled by adjusting the position of the boundary surface between the gas and liquid phases. Since vaporization can thus be carried out smoothly, it is possible to supply a source gas at a constant rate without causing ripples of the kind shown in Fig. 3.

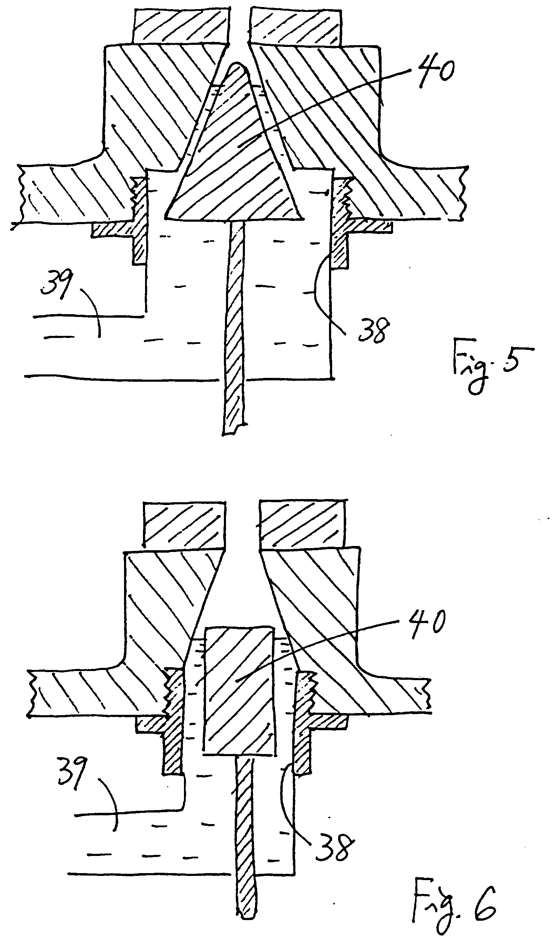

The embodiment of the invention described above with reference to Fig. 4 is not intended to be limitative, but rather as being illustrative. Many modifications and variations are conceivable within the scope of the invention. For example, Fig. 4 is not intended to show a preferred shape of the inserted member 40 for partially blocking the passageway 38 or a preferred configuration of the passageway 38 itself. The member 40 need not be shaped like a bullet as shown in Fig. 4. It may be shaped like a cone with a rounded head as shown in Fig. 5 and the passageway 38 may be uniformly tapered near the top as the same tapering angle. This embodiment is particularly preferable because the cross-sectional area of the gap through which the source liquid travels can be controlled more accurately by adjusting the vertical position of the blocking member 40. Fig. 6 shows still another embodiment wherein the inserted member 40 is not tapered.

In summary, liquid vaporization valves according to the present invention are capable of preventing a liquid from accumulating inside the passageway such that there is no oversupply of liquid when the valve is switched on. As a result, ripples of the type shown in Fig. 3 will not occur, and the vaporization of the source liquid can take place smoothly. Since the source gas can thus be supplied at a constant rate into the reaction chamber, yields, for example, of semiconductor wafers manufactured therein, can be significantly improved.

Although the advantages of the present invention have been described above with reference to its application to the supply of source liquid to an apparatus for the fabrication of semiconductor wafers, it goes without saying that the present invention is applicable widely in chemical industries and, in particular, to the liquid vaporization valve of a vaporizer-feeder for transporting at a high level of accuracy a liquid such as alcohols and organic acids to a reaction chamber in a reduced-pressure condition.

## Claims

1. Liquid vaporization valve (30) for mixing a carrier gas with a source gas obtained by vaporizing a source liquid, said valve comprising a passageway (38) and said liquid vaporization valve having a downstream end for allowing said source liquid (2) to pass therethrough towards said downstream end, characterized in that:
an elongated member (40) is inserted into said passageway (38) for controlling the flow rate of said source liquid therethrough towards said downstream end.

2. The liquid vaporization valve of claim 1 wherein said flow rate controlling means (40) comprises an elongated tapered member.

3. The liquid vaporization valve of claim 1 wherein said flow rate controlling means comprises an elongated member (40) without a taper and said passageway (38) has a tapered inner wall.

4. The liquid vaporization valve of claim 2 wherein said passageway (38) has a tapered inner wall.

5. The liquid vaporization valve of any one of the preceding claims, which is a three-way valve (30) including a gas inlet (36) and a gas outlet (37).

6. The liquid vaporization valve of claim 5 wherein said downstream end of said passageway (38) is opening to a gas conduit between said gas inlet (36) and said gas outlet (37).

## Patentansprüche

1. Flüssigkeitsverdampfungsventil (30) zum Mischen eines Trägergases mit einem durch Verdampfung einer Quellenflüssigkeit erhaltenen Quellengas, wobei das Ventil einen Durchlaßweg (38) umfaßt und das Flüssigkeitsverdampfungsventil ein stromabwärts gelegenes Ende aufweist, um der Quellenflüssigkeit (2) zu ermöglichen, in Richtung auf das stromabwärts gelegene Ende dadurch hindurchzuströmen, dadurch gekennzeichnet, daß:
ein längliches Element (40) in den Durchlaßweg (38) eingefügt ist, um die Flußrate der Quellenflüssigkeit dadurch hindurch in Richtung auf das stromabwärts gelegene Ende zu steuern.

2. Flüssigkeitsverdampfungsventil gemäß Anspruch 1, bei dem das Flußratensteuerungsmittel (40) ein längliches verjüngtes Element aufweist.

3. Flüssigkeitsverdampfungsventil gemäß Anspruch 1, bei dem das Flußratensteuerungsmittel ein längliches Element (40) ohne Verjüngung umfaßt und der Durchlaßweg (38) eine verjüngte Innenwand aufweist.

4. Flüssigkeitsverdampfungsventil gemäß Anspruch 2, bei dem der Durchlaßweg (38) eine verjüngte Innenwand aufweist.

5. Flüssigkeitsverdampfungsventil gemäß einem der vorhergehenden Ansprüche, bei dem es sich um ein Dreiwegventil (30) mit einem Gaseinlaß (36) und einem Gasauslaß (37) handelt.

6. Flüssigkeitsverdampfungsventil gemäß Anspruch 5, bei dem sich das stromabwärts gelegene Ende des Durchlaßweges (38) hin zu einem Gaskanal zwischen dem Gaseinlaß (36) und dem Gasauslaß (37) öffnet.

## Revendications

1. Vanne (30) de vaporisation de liquide, destinée à mélanger un gaz porteur avec une source gazeuse obtenue par vaporisation d'une source liquide, ladite vanne comprenant un passage (38) et ladite vanne de vaporisation de liquide présentant une extrémité aval pour permettre à ladite source liquide (2) de passer à travers celle-ci, en direction de ladite extrémité aval, caractérisée en ce que :
un élément allongé (40) est inséré dans ledit passage (38) pour commander le débit d'écoulement de ladite source liquide à travers celui-ci, en direction de ladite extrémité aval.

2. Vanne de vaporisation de liquide selon la revendication 1, dans laquelle lesdits moyens de commande (40) du débit d'écoulement sont constitués d'un élément effilé allongé.

3. Vanne de vaporisation de liquide selon la revendication 1, dans laquelle lesdits moyens de commande du débit d'écoulement sont constitués d'un élément allongé (40) non effilé et ledit passage (38) a une paroi intérieure effilée.

4. Vanne de vaporisation de liquide selon la revendication 2, dans laquelle ledit passage (38) a une paroi intérieure effilée.

5. Vanne de vaporisation de liquide selon l'une quelconque des revendications précédentes, qui est une vanne à trois voies (30) comprenant une entrée de gaz (36) et une sortie de gaz (37).

6. Vanne de vaporisation de liquide selon la revendication 5, dans laquelle ladite extrémité aval dudit passage (38) débouche sur une conduite de gaz située entre ladite entrée de gaz (36) et ladite sortie de gaz (37).
